# EUROPÄISCHE PATENTSCHRIFT

(11) **EP 0 448 782 B1**
(45) Veröffentlichungstag und Bekanntmachung des Hinweises auf die Patenterteilung: **16.06.1993**
(21) Anmeldenummer: 90122160.6
(22) Anmeldetag: 20.11.1990
(51) Int. Cl.: C23C 14/56, C23C 14/50, H01L 21/00

(54) **Vorrichtung zum Ein- und Ausschleusen eines Werkstücks in eine Vakuumkammer**
Apparatus for loading and unloading an article into a vacuum chamber
Dispositif de chargement et de déchargement d'une pièce dans une chambre à vide

(30) Priorität: 26.03.1990 DE 4009603
(43) Veröffentlichungstag der Anmeldung: 02.10.1991
(73) Patentinhaber: LEYBOLD AKTIENGESELLSCHAFT, D-63450 Hanau (DE)
(72) Erfinder: Kempf, Stefan, W-8755 Alzenau (DE); Zejda, Jaroslav, W-6458 Rodenbach 1 (DE)

(56) Entgegenhaltungen:
- EP-A- 0 161 928
- EP-A- 0 354 294
- EP-A- 0 389 820
- FR-A- 2 252 419
- US-A- 4 943 363

## Beschreibung

Die Erfindung betrifft eine Vorrichtung zum Ein- und Ausschleusen eines Werkstücks in eine Vakuumkammer, in der sich ein Transportmittel für die Beförderung des Werkstücks befindet.

In der Vakuumverfahrenstechnik, insbesondere in der Dünnschichttechnik ist das Beschichten von Substraten, beispielsweise von Compactdiscs (CD) bekannt. Die Compactdiscs sind ein modernes Speichermedium für digitale Informationen. In einem Sputterprozeß werden die geprägten Kunststoffscheiben mit beispielsweise einer Aluminiumschicht von weniger als einem zehntausendstel Millimeter überzogen.

Die hierzu eingesetzten Sputterbeschichtungsanlagen besitzen in vielen Fällen einen Drehteller für die Beförderung der Substrate.

Über eine Schleuse in einem Sauberraum belädt und entlädt ein Roboter die Anlage. Von der Schleuse aus transportiert der Drehteller den Substratträger mit dem Substrat durch die Vakuumkammer. Das Besputtern erfolgt durch eine Hochleistungszerstäubungskatode, die als Magnetron aufgebaut ist.

Durch die Deutsche Offenlegungsschrift 3716498 ist bereits eine Vorrichtung zum Ein- und Ausschleusen eines im wesentlichen flachen Werkstücks in eine evakuierte Beschichtungskammer und zum Zurückführen und Rückführen des Werkstücks in und aus dem Bereich einer Beschichtungsquelle zum Zwecke der Behandlung der Werkstückoberfläche bekannt geworden.

Die Vorrichtung nach dieser Offenlegungsschrift ist gekennzeichnet durch eine im Bereich der Beschichtungskammer angeordnete Beschichtungsvorrichtung mit einem oder mehreren deckelförmige Werkstückträgern, mit Hilfe derer die Werkstücke in eine einer Öffnung der Beschichtungskammer benachbarte Position bringbar sind, von der aus die Öffnung einerseits vom Werkstückträger und andererseits von einem Hubteller verschließbar ist, der auf einem innerhalb der Beschichtungskammer rotierbar gelagerten Drehteller gehalten und geführt ist, wobei der Werkstückträger von einem sich an der Beschickungsvorrichtung abstützenden Hubzylinder an die Öffnung im Deckel der Beschichtungskammer und der Hubteller von einer an der Bodenplatte befestigten Hubvorrichtung anpreßbar ist.

Weiterhin existiert die US-Patentschrift 3915117. Die Kurzfassung (Abstract) dieser Patentschrift lautet in deutscher Übersetzung wie folgt:

Eine Beschichtungsanlage zum Beschichten verschiedener Produkte umfaßt ein Gehäuse. Das Gehäuse besteht aus einem festen Teil und einem rotierenden Abdeckungsteil. Beide Teile bilden zusammen eine geschlossene gasdichte Gehäusekammer. Die Gehäusekammer kann evakuiert werden. Eine Vielzahl von Produktträgern werden auf den bewegbaren Teil des Gehäuses getragen. Die Produkthalter sind mit Abstand voneinander angeordnet. Sie sind bewegbar, damit sie in verschiedene Operationsstationen gebracht werden können. Eine dieser Operationsstationen umfaßt vorzugsweise eine gasdichte Beschichtungskammer. Diese Kammer ist verbindbar mit der gasdichten Gehäusekammer. Die Operationsstation ist mit getrennten Mitteln zur Evakuierung der Beschichtungskammer versehen. Es sind bewegbare Dichtungsmittel an wenigstens einer Station vorgesehen. Die Dichtungsmittel dienen zur Dichtung der Beschichtungskammer und zu deren Trennung von der Gehäusekammer. In gleicher Weise ist eine Beschickungskammer vorzugsweise in einer separaten Station angebracht. Sie ist separat verbindbar mit der Gehäusekammer. Alternativ kann sie von der Gehäusekammer getrennt werden und getrennt evakuiert werden.

Es existiert weiterhin die europäische Anmeldung EP-A-0161928. Sie befaßt sich mit einem System für die Rotation einer Transferplatte eines Beschichtungssystems in einer Vakuumkammer.

Im einzelnen wird, siehe hierzu die Figuren 4, 5 und 6 der soeben genannten europäischen Anmeldung, eine Druckplatte 16 gegen die Transferplatte 18 gedrückt. Die Transferplatte ihrerseits wird gegen die Wand 32 gedrückt.

Die Transferplatte der genannten europäischen Anmeldung rotiert um eine horizontal angeordnete Achse. Die Transferplatte des Standes der Technik ist daher vertikal angeordnet.

Demgegenüber, siehe hierzu die nachfolgende Beschreibung, wird beim Gegenstand der Erfindung ein horizontal angeordnetes scheibenförmiges Transportmittel benutzt.

Es existiert die im Sinne des Artikel 54, Absatz 3, und Artikel 56, Satz 2, EPÜ, ältere europäische Patentanmeldung EP-A-389820. In dieser älteren Anmeldung wird eine Vorrichtung zum Ein- und Ausschleusen eines Werkstücks in eine Vakuumkammer, in der sich ein Transportmittel für die Beförderung des Werkstücks befindet, beschrieben.

Das Besondere des Gegenstands der älteren Anmeldung besteht darin, daß ein horizontal angeordnetes, scheibenförmiges Transportmittel vorgesehen ist, das mindestens eine durchgehende, vertikale Öffnung aufweist, daß eine separate Haltevorrichtung beim Ein- und Ausschleusen eines Werkstücks innerhalb der vertikalen Öffnung in vertikaler Richtung bewegbar und gegen Teile der Vakuumkammer anpreßbar ist, wodurch die Vakuumkammer beim Ein- und Ausschleusen abgedichtet ist, vorgesehen ist, daß eine separate Hub- und Stützvorrichtung für die vertikale Bewegung der Haltevorrichtung innerhalb der vertikalen Öffnung und für die Anpressung der Haltevorrichtung gegen Teile der Vakuumkammer vorgesehen ist.

Der Gegenstand dieser älteren Anmeldung soll durch die vorliegende Erfindung verbessert werden.

Die Vorrichtungen des Standes der Technik weisen in der Praxis folgende weitere Nachteile auf:

Der gesamte Drehteller muff sehr massiv ausgeführt werden. Ebenfalls ist, um Durchbiegungen, siehe dazu der weiter unten folgende Kommentar zur Biegebeanspruchung des Substratträgers, zu vermeiden, eine massive Ausführung des Substratträgers notwendig.

Während der Verfahrenszyklen müssen daher große Massen transportiert werden. Aufgrund der dadurch auftretenden großen Massenträgheitsmomente laufen die Verfahrenszyklen entsprechend langsam ab. Einer ökonomischeren und rationelleren Arbeitsweise sind daher bei den Anlagen des Standes der Technik Grenzen gesetzt.

Der Substrathalter muß deshalb bei Vorrichtungen des Standes der Technik sehr massiv ausgeführt werden, weil beim Hochfahren der Hubvorrichtungen für den Substrathalter und beim Abstützen des Substrathalters an Teilen der Vakuumkammer der Substrathalter selbst hohen Biegebeanspruchungen ausgesetzt ist.

Bei Anlagen des Standes der Technik ist neben der massiven Ausführung von Drehteller und Substrathalter, auch der Aufwand an Einzelteilen sehr hoch. Dieser Aufwand multipliziert sich mit der Anzahl der Substrathalter im Drehteller.

Der Erfindung liegen folgende Aufgaben zugrunde:

Die geschilderten Nachteile des Standes der Technik sollen vermieden werden. Es sollen konstruktive Voraussetzungen geschaffen werden für eine filigrane und leichte Ausführung des Drehtellers und des Substrathalters.

Der Drehteller soll im wesentlichen nur die funktionsnotwendigen Teile für die Aufnahme des Substrathalters umfassen. Es soll nicht mehr notwendig sein, massive Komponenten einzusetzen, um Verbiegungen und andere Deformationen zu vermeiden. Die Massenträgheitsmomente sollen verringert werden. Die Arbeitszyklen sollen schneller ablaufen. Die Verlustzeiten, die durch das Rotieren des Drehtellers entstehen, sollen reduziert werden.

Es soll möglich sein, mehr Substrathalter, als dies beim Stand der Technik der Fall ist, in einem Drehteller unterzubringen.

Außerdem soll es durch die Einführung einer filigranen Bauweise möglich gemacht werden, daß die Abmessungen der Kammer (Kammerdicke, Kammervolumen) erheblich optimiert werden können.

Ein besonderer Vorteil, den der Gegenstand der vorliegenden Erfindung im Vergleich zum Stand der Technik, namentlich im Vergleich zu der älteren europäischen Patentanmeldung EP-A-389820, aufweist, wird wie folgt erläutert:

In der Vakuumbeschichtungstechnik strebt man aus wirtschaftlichen Gründen möglichst kleine Vakuumräume an. Die Vakuumkammer soll von dünner spaltförmiger Konfiguration, die sich im Bereich zwischen dem Drehteller und der Unterwand des Vakuumdeckels erstreckt, sein. Bei Verwerfungen, Wellen oder sonstigen Unebenheiten der Substrate kann es beim seitlichen Einschieben in die spaltförmige Vakuumkammer zum Verklemmen der Substrate kommen.

Mit dem Gegenstand der vorliegenden Erfindung werden die soeben genannten Nachteile beseitigt.

Außerdem wird ein störungsfreies Arbeiten der Sputteranlage auch dann gewährleistet, wenn die Substrate Unebenheiten aufweisen.

Schließlich wird erreicht, daß die bewegten Teile eine möglichst geringe Masse aufweisen.

Die gestellten Aufgaben werden erfindungsgemäß dadurch gelöst, daß ein horizontal angeordnetes, scheibenförmiges Transportmittel vorgesehen ist, das mindestens eine durchgehende, vertikale Öffnung aufweist, daß eine separate Haltevorrichtung für ein Werkstück, wobei diese Haltevorrichtung beim Ein- und Ausschleusen eines Werkstücks innerhalb der vertikalen Öffnung in vertikaler Richtung bewegbar und gegen Teile der Vakuumkammer anpreßbar ist, wodurch die Vakuumkammer beim Ein- und Ausschleusen abgedichtet ist, vorgesehen ist, daß eine separate Hub- und Stützvorrichtung für die vertikale Bewegung der Haltevorrichtung innerhalb der vertikalen Öffnung und für die Anpressung der Haltevorrichtung gegen Teile der Vakuumkammer vorgesehen ist, daß die Haltevorrichtung im wesentlichen als Ring ausgebildet ist (Substrathaltering), der das Werkstück im Bereich seines äußeren Randes aufnimmt.

Eine bevorzugte Ausführungsform besteht darin, daß der Substrathaltering (41, 57) im Bereich seines äußeren Umfangs, vorzugsweise durch einen Absatz, in der Aufnahmeöffnung des Drehtellers (47, 53) gehalten wird, daß der Substrathaltering einen sich zur Mitte hin erstreckenden Absatz für die Ablage des Substrats aufweist.

In einem weiteren Ausführungsbeispiel wird vorgeschlagen, daß die Stützplatte (37) Hutform aufweist und mit einem krempenartig ausgebildeten, sich radial nach außen erstreckenden Flansch (38) versehen ist, daß der Substrathaltering (41) auf dem Flansch aufliegt.

Funktionell kann vorgesehen werden, daß der Substrathaltering (41, 57) als Zentrierring für das Substrat ausgebildet ist.

Eine sehr vorteilhafte Ausgestaltung besteht darin, daß der Substrathaltering (41, 57) im Bereich der Ein- und Ausschleusung als Dichtelement für die Vakuumkammer ausgebildet ist.

Dieser Gedanke wird dadurch ergänzt, daß der Substrathaltering (41) in der oberen Position der Stützplatte zwischen der Wandung (42) der Vakuumkammer (46), insbesondere der Innenfläche des Deckels der Vakuumkammer, und der Stützplatte (37) dichtend eingeklemmt ist.

Mit der Erfindung werden folgende Vorteile erreicht:

Die gestellten Aufgaben werden gelöst, insbesondere werden die geschilderten Nachteile des Standes der Technik vermieden.

Es werden konstruktive Voraussetzungen geschaffen für eine leichte Ausführung des Drehtellers und des Substrathalters. Beide Bauteile sind bis auf ihre funktionswesentlichen Komponenten abgemagert.

Aufgrund der stark reduzierten Massenträgheitselemente laufen die Arbeitszyklen schneller ab. Gleichzeitig werden die für das ökonomische Arbeiten der Beschichtungsanlage wichtigen Daten, wie die Abmessungen der Kammer (Kammerdicke, Kammervolumen) wesentlich verbessert.

Mit dem Gegenstand der Erfindung wird eine hohes Maß an Unempfindlichkeit gegenüber Unebenheiten des Substrats erreicht.

Weitere Einzelheiten der Erfindung sind der folgenden Beschreibung dreier Ausführungsbeispiele der Erfindung zu entnehmen:

Figur 1 zeigt in einem Schnittbild eine Vorrichtung zum Ein- und Ausschleusen einer Disk in eine Vakuumkammer einer Beschichtungsanlage, die mit einer nicht dargestellten Katodenstation ausgerüstet ist. Es handelt sich um den Gegenstand der älteren europäischen Patentanmeldung EP-A-389820.

Die Figuren 2 und 3 zeigen zwei Ausführungsbeispiele der erfindungsgemäßen Vorrichtung zum Ein- und Ausschleusen einer Disk.

Bei der nachfolgenden Beschreibung des Ausführungsbeispiels wird von einem Stand der Technik ausgegangen, wie er sich in Form der oben genannten Schriften darstellt. Die Beschreibung und die Figuren dieses Standes der Technik können daher zur Erläuterung der Ausgangsbasis für die nachfolgend beschriebenen Ausführungsbeispiele herangezogen werden.

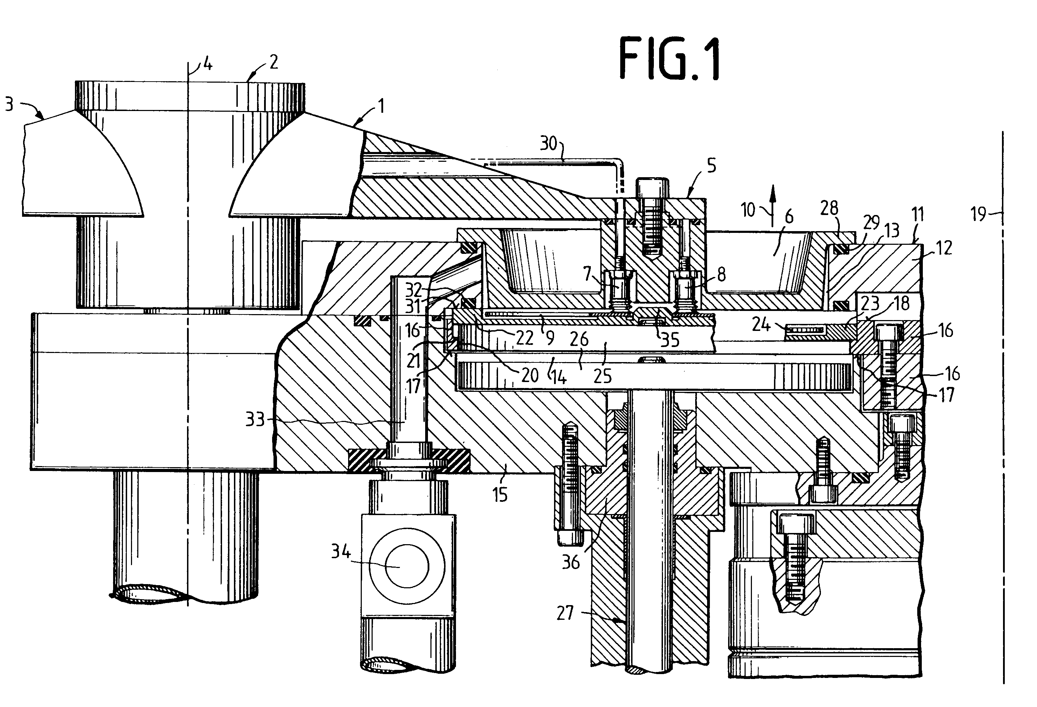

Mit 1 ist in Figur 1 ein Querbalken bezeichnet, der durch das Aggregat 2 heb- und senkbar und drehbar ist. Der Querbalken gehört zu einer Transporteinrichtung, die mit einem Doppelschwenkarm ausgerüstet ist. Der erste Schwenkarm, im vorliegenden Fall der Querbalken 1, ist in der Figur dargestellt. Der zweite Querbalken, der dem ersten Querbalken 1 gegenüberliegend angeordnet ist, ist nur teilweise dargestellt. Er trägt die Bezugsziffer 3.

Der Doppelschwenkarm ist drehbar, und zwar um die Achse 4. Durch Verdrehen wird der erste Querbalken in die Position des zweiten Querbalkens gebracht, während der zweite Querbalken in die Position des ersten Querbalkens gelangt.

Am rechten Ende 5 des Querbalkens ist ein Deckel 6 angeordnet. Im Deckel sind drei Saugvorrichtungen, von denen zwei Saugvorrichtungen 7, 8 in der Figur dargestellt sind, untergebracht, die zum Ansaugen, das heißt Festhalten, eines Substrats dienen. Im vorliegenden Fall besteht das Substrat aus einer Disk 9, von der in der Figur nur der linke Teile dargestellt ist. Wenn der Querbalken durch das Aggregat gehoben wird, hebt er den Deckel 6 in Richtung des Pfeils 10. Nachdem der Deckel oberhalb der Oberkante 11 des Vakuumkammerdeckels 12 gelangt ist, kann der Querbalken um 180 Grad gedreht werden, siehe oben.

Die im Vergleich zur Vakuumkammer kleine Einschleuskammer 13 ist trennbar von der Vakuumkammer 14 der Beschichtungsanlage, wie weiter unten noch im einzelnen beschrieben werden wird. Das Unterteil der Vakuumkammer trägt die Bezugsziffer 15.

In der vorliegenden Figur ist nur der Teil der Vakuumkammer gezeigt, der funktionsmäßig mit der Einschleusstation zusammenwirkt. Die Vakuumkammer ist im vorliegenden Ausführungsbeispiel flach ausgeführt. In ihr ist ein Drehteller 15 untergebracht. Die Bezugsziffer 16 ist mehrfach in der Figur eingetragen, um die Konfiguration des Drehtellers deutlich zu machen. In der Figur ist nur der Teil des Drehtellers gezeigt, der mit der Schleusenstation zusammenwirkt.

Mit 17 ist die Unterkante des Drehtellers bezeichnet. Die Bezugsziffer 17 ist zur Verdeutlichung der Position dieser Unterkante zweifach eingetragen. 18 stellt die Oberkante des Drehtellers dar. Der Drehteller kann innerhalb der Vakuumkammer, die mit 14 bezeichnet ist, um die Achse 19 rotieren.

Der Drehteller kann beispielsweise vier Aufnahmeöffnungen aufweisen, von denen eine in der Figur dargestellt ist und dort die Bezugsziffer 20 trägt. Die Aufnahmeöffnung besteht aus einer zylinderförmigen Ausnehmung im flachen Drehteller 16.

Wegen der gewählten Schnittdarstellung bildet sich die Aufnahmeöffnung als Linie 20 ab. Es handelt sich um die Begrenzungslinie oder die geschnittene Mantelfläche der zylinderförmigen Ausnehmung.

Im Bereich des Randes, beziehungsweise der Mantelfläche 20, der Aufnahmeöffnung im Drehteller 16 ist ein Absatz 21 vorgesehen, auf den sich der Substrathalter 22 setzen kann.

In der Figur rechts ist ein Substrathalter 23 gezeigt und zwar in seiner, auf dem umlaufenden Absatz 21 abgesetzten Position. Links ist der Substrathalter, siehe oben, mit 22 bezeichnet und zwar in seiner angehobenen Position.

Mit 24 ist das Substrat, beziehungsweise die Disk, bezeichnet, die im Substrathalter liegt.

Mit 25, 26 sind zwei Positionen einer Stützplatte gekennzeichnet, wobei 25 die Stützplatte in ihrer oberen Position und 26 die Stützplatte in ihrer unteren Position bezeichnen. Die Stützplatte wird axial bewegt durch eine Hubvorrichtung 27.

36 bezeichnet ein Dichtungs- und Führungsteil. Der Bereich 14 ist, siehe oben, Teil der Vakuumkammer. Er steht also auch während des Be- und Entladens unter Vakuum.

Nachfolgend wird die Verfahrensweise für das Ein- und Ausschleusen eines Werkstücks, hier einer Disk, beschrieben:

In einer Position des Querbalkens 1, die um 180 Grad zu der in der Figur gezeigten Position verschwenkt angeordnet ist, wird durch die Saugvorrichtung 7, 8 eine Disk aufgenommen, das heißt angesaugt. Der Querbalken 1 und damit der Deckel 6 und die Disk 9 werden angehoben und anschließend um 180 Grad um die Achse 4 verschwenkt. Sie sind dann in einer Position oberhalb derjenigen Position, die in der Figur gezeigt ist.

Anschließend wird der Querbalken mit Deckel und Disk abgesenkt und gelangt in die Position, wie sie in der Figur dargestellt ist. Der Rand 28 des Deckels liegt dichtend auf der Dichtung 29 auf. Es handelt sich hierbei vorzugsweise um einen O-Ring.

Die Saugleitung 30, beziehungsweise Vakuumleitung für die Saugvorrichtungen 7, 8 wird abgeschaltet, so daß der Saugeffekt, beziehungsweise Halteeffekt, fortfällt. Die Disk 9 legt sich in den Substrathalter 22.

Die Stützplatte ist vorher in die Position 25 durch die Hubvorrichtung 27 angehoben worden. Der Substrathalter 22 wird durch die Stützplatte gegen die untere Wand 31 der Vakuumkammer beziehungsweise gegen die Dichtung (O-Ring) 32 gepreßt. Die Einschleuskammer 13 ist nunmehr luftdicht gegenüber der Atmosphäre und gegenüber der Vakuumkammer abgeschlossen.

Die Einschleuskammer wird über die Leitung 33 anschließend evakuiert. Das Schleusenventil 34 ist entsprechend geschaltet.

Nach der Evakuierung der Einschleuskammer 13 fährt die Stützplatte in ihre untere Position, die mit 26 bezeichnet ist. Die Einschleuskammer 13 wird nunmehr mit der Vakuumkammer 14 verbunden. Der Substrathalter mit der Disk setzt sich auf den Absatz 21 in der Aufnahmeöffnung des Drehtellers 16. In dieser Position ist in der Figur rechts der Substrathalter mit 23 bezeichnet, siehe oben. Das im Substrathalter 23 liegende Substrat trägt in Figur rechts die Bezugsziffer 24.

Der Drehteller kann nun, nach dem Absenken der Stützplatte, zusammen mit dem Substrathalter, der sich unter der Wirkung seines Eigengewichts, wie dargestellt, auf den ringförmigen Absatz 21 des Drehtellers abgesetzt hat und zusammen mit dem im Substrathalter liegenden Substrat, innerhalb der Vakuumkammer rotieren. Das Substrat wird innerhalb der Vakuumkammer zu weiteren Stationen, beispielsweise zu einer Beschichtungsquelle in Form einer Zerstäubungskatode, transportiert.

Es können beispielsweise vier Stationen in der Vakuumkammer angeordnet sein. Der Drehteller würde sich dann im Takt um jeweils 90 Grad drehen. Nach vier Takten wäre eine Arbeitszyklus beendet und das beschichtete Substrat gelangt in die in der Figur mit 24 bezeichnete Position. Es folgt der Ausschleusvorgang.

Die Stützplatte wird bei Beginn des Ausschleusvorgangs aus ihrer Position 26 in die Position 25 gehoben. Damit gelangt das Substrat, beziehungsweise die Disk, aus der Position 23, 24 in die Position 22, 9. Der Substratträger 22 wird durch die Stützplatte 25 gegen die Dichtung 32 gepreßt.

Die Einschleuskammer wird dadurch von der Vakuumkammer getrennt. Anschließend wird die Einschleuskammer über die Leitung 33 durch entsprechende Schaltung des Schleusenventils 34 geflutet.

Nachdem die Schleusenkammer geflutet ist, werden durch Öffnen der Saugleitung 30 die Saugvorrichtungen aktiviert, so daß die Saugvorrichtungen die Disk ansaugen und festhalten können.

Anschließend wir der Deckel durch den Querbalken gehoben und danach um 180 Grad geschwenkt. Die beschichtete Disk wird in der nicht dargestellten linken Position von den Saugvorrichtungen freigegeben.

Zusammenfassend kann also gesagt werden, daß in einem Drehteller mehrere dünne membranartige Substratträger angeordnet sind. In der Vertiefung der Substratträger wird das Substrat zentriert abgelegt.

Die Zentrierung der Substrate, beziehungsweise Disks, erfolgt durch einen Vorsprung 35 im Zentrum des Substrathalters.

In der Einschleusstation werden die dünnen membranartigen Substratträger von einer Stützplatte gegen eine Dichtung, insbesondere einen O-Ring, gedrückt und bilden so mit dem Vakuumkammerdeckel und dem darüber angeordneten Deckel 28 die Einschleus- oder Ausschleuskammer 13. Der Substrathalter besteht aus einem relativ einfachen Drehteil, vorzugsweise aus Aluminium.

Die Stützplatte 25, 26 ist nur in der Ein- und Ausschleusstation vorgesehen.

Die Stützplatte verhindert das Durchbiegen des dünnen Substrathalters. Auch der Drehteller selbst kann, wie aus der Figur ersichtlich, sehr dünn ausgelegt werden.

Damit werden die Massenträgheitsmomente des Drehtellers und der vier Substrathalter erheblich reduziert.

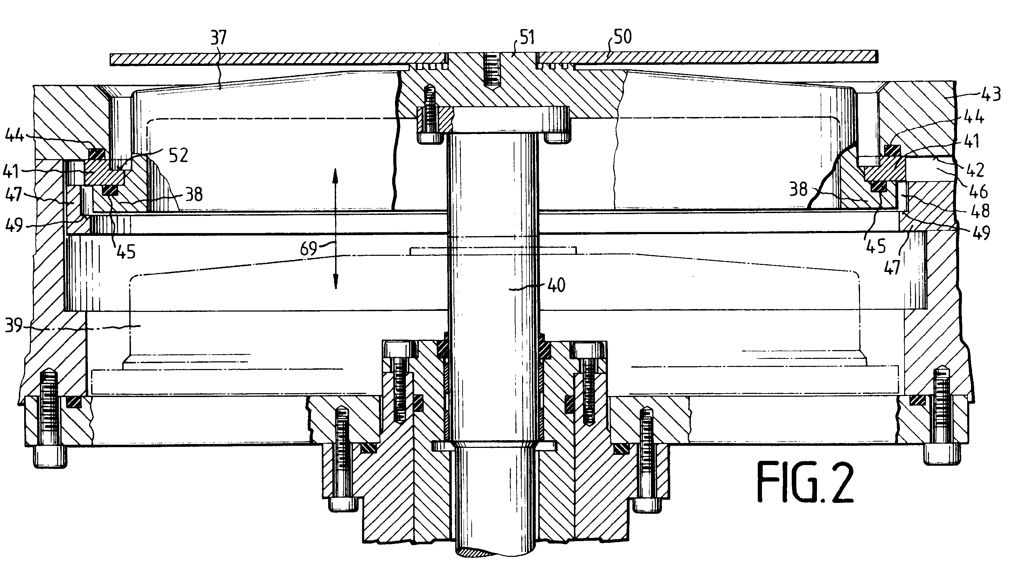

Der Figur 2 sind Einzelheiten eines ersten Ausführungsbeispiels des Gegenstands der Erfindung zu entnehmen. Die Stützplatte weist hier eine Hutform auf mit einem krempenartigen Flansch. Diese hutförmige Stützplatte ist in ihrer oberen Position mit 37 bezeichnet. Der Flansch trägt die Bezugsziffer 38. Die Bewegungen der Stützplatte werden durch den Pfeil 69 wiedergegeben.

Auch im Ausführungsbeispiel nach Figur 2 sind Bauteile mehrfach mit ihren Bezugsziffern versehen, um die Konfiguration dieser Bauteile zu verdeutlichen.

So ist beispielweise der Flansch zweimal mit der Bezugsziffer 38 bezeichnet.

In seiner unteren Position ist die Stützplatte mit 39 bezeichnet. Die Hubvorrichtung für die Stützplatte trägt die Bezugsziffer 40.

Aus Figur 2 ist erkennbar, daß als Haltevorrichtung ein Substrathaltering 41 in der oberen Position 37 der Stützplatte zwischen dem Flansch 38 der Stützplatte und der unteren Fläche 42 des Deckels 43 der Vakuumkammer eingeklemmt gehalten wird.

Zur Abdichtung ist in dem Deckel 43 der Vakuumkammer die Dichtung 44 vorgesehen. Im Flansch 38 befindet sich die Dichtung 45.

In der in Figur 2 dargestellten Situation ist der Substrathaltering zwischen den soeben genannten Dichtungen eingeklemmt. Er bildet somit ein Abdichtelement für die Vakuumkammer 46.

Der Drehteller ist in Figur 2 mit 47 bezeichnet. Er weist die Aufnahmeöffnung 48 auf, in der der Substrathaltering bei der Abwärtsbewegung der Stützplatte aufgenommen wird. Der Substrathaltering sitzt auf dem Absatz 49 in der Aufnahmeöffnung des Drehtellers auf.

Das Substrat ist mit 50 bezeichnet, es wird durch den Vorsprung 51 der Stützplatte während des Ein- und Ausschleusvorgangs zentriert. Bei der Abwärtsbewegung der Stützplatte nach unten wird das Substrat auf dem Absatz 52 des Substrathalterings abgelegt und durch den Substrathaltering zentriert.

Die Funktionsabläufe, insbesondere die Ein- und Ausschleusvorgänge entsprechen den Vorgängen, wie sie anhand von Figur 1 beschrieben wurden. In Figur 2 ist aus Vereinfachungsgründen der Deckel, siehe in Figur 1 Bezugsziffer 6, fortgelassen worden.

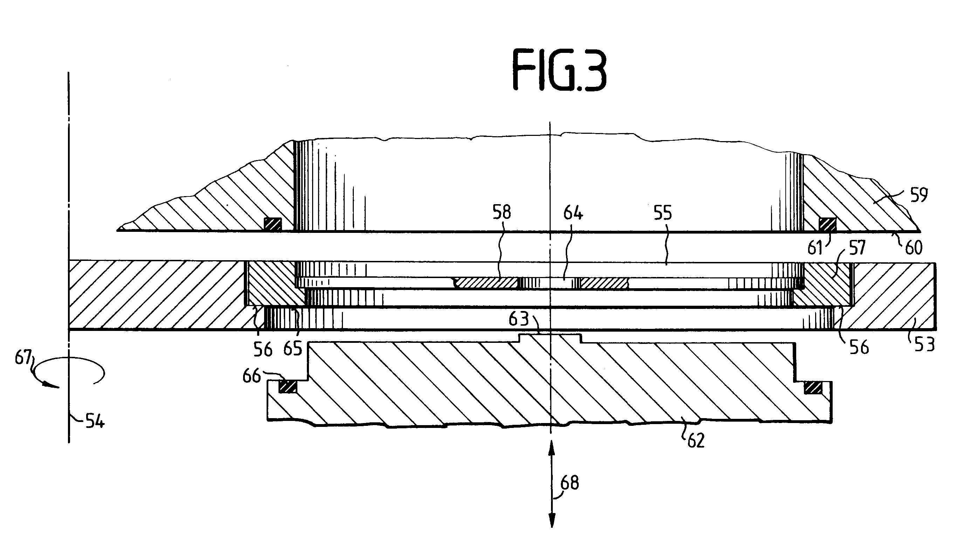

In Figur 3 ist ein weiteres Ausführungsbeispiel der Erfindung der Erfindung dargestellt. Der Drehteller trägt die Bezugsziffer 53, die Drehachse des Drehtellers ist mit 54 bezeichnet. Der Drehteller weist eine Aufnahmeöffnung 55 auf, die mit einem Absatz 56 versehen ist. Auf diesem Absatz ruht der Substrathaltering 57 mit dem Substrat 58. Der Deckel der Vakuumkammer ist beim Ausführungsbeispiel nach Figur 3 mit 59 bezeichnet.

An seiner unteren Fläche 60 weist dieser Deckel eine Dichtung 61 auf, die beim Hochfahren des Substrathalterings dichtend am Substrathaltering anliegt.

Die Stützplatte zum Bewegen des Substrathalterings trägt die Bezugsziffer 62. Die Stützplatte ist in Figur 3 in ihrer unteren Stellung wiedergegeben. Sie weist einen Vorsprung 63 auf, der in die Öffnung 64 des Substrats fährt und dadurch das Substrat während des Ein- und Ausschleusens zentriert. Während der Beschichtung wird das Substrat durch den Substrathaltering 57 zentriert.

Die untere Fläche 65 des Substrathalterings gelangt beim Hochfahren der Stützplatte in abdichtende Berührung mit der Dichtung 66 der Stützplatte. Diese Dichtung ist in einem Absatz der Stützplatte angeordnet.

Im hochgefahrenen Zustand der Stützplatte wird eine Abdichtung der Vakuumkammer durch die Dichtung 66, den eingeklemmten Substrathaltering 57 und die Dichtung 61 erreicht.

Der Pfeil 67 bezeichnet die Rotation des Drehtellers 53. Der Doppelpfeil 67 gibt die Bewegungen der Stützplatte 62 wieder.

Der in Figur 1 mit 6 bezeichnete Deckel ist auch bei dem Ausführungsbeispiel nach Figur 3 aus Vereinfachungsgründen nicht eingezeichnet. Die Funktionsabläufe, insbesondere die Ein- und Ausschleusvorgänge, sind bei der Vorrichtung nach Figur 3 die gleichen, wie sie anhand von Figur 1 beschrieben wurden.

Die Gegenstände der Figuren 2 und 3 dienen insbesondere zur Lösung der Aufgabe, die darin besteht, konstruktive Voraussetzungen dafür zu schaffen, daß die Anlage auch dann störungsfrei arbeitet, wenn die Substrate Unebenheiten aufweisen.

## Patentansprüche

1. Vorrichtung zum Ein- und Ausschleusen eines Werkstücks in eine Vakuumkammer, in der sich ein Transportmittel für die Beförderung des Werkstücks befindet, dadurch **gekennzeichnet,** daß ein horizontal angeordnetes, scheibenförmiges Transportmittel vorgesehen ist, das mindestens eine durchgehende, vertikale Öffnung aufweist, daß eine separate Haltevorrichtung beim Ein- und Ausschleusen eines Werkstücks innerhalb der vertikalen Öffnung in vertikaler Richtung bewegbar und gegen Teile der Vakuumkammer anpreßbar ist, wodurch die Vakuumkammer beim Ein- und Ausschleusen abgedichtet ist, vorgesehen ist, daß eine separate Hub- und Stützvorrichtung für die vertikale Bewegung der Haltevorrichtung innerhalb der vertikalen Öffnung und für die Anpressung der Haltevorrichtung gegen Teile der Vakuumkammer vorgesehen ist, daß die Haltevorrichtung im wesentlichen als Ring ausgebildet ist (Substrathaltering), der das Werkstück im Bereich seines äußeren Randes aufnimmt.

2. Vorrichtung nach Anspruch 1, dadurch **gekennzeichnet,** daß der Substrathaltering (41, 57) im Bereich seines äußeren Umfangs, vorzugsweise durch einen Absatz, in der Aufnahmeöffnung des Drehtellers (47, 53) gehalten wird, daß der Substrathaltering einen sich zur Mitte hin erstreckenden Absatz für die Ablage des Substrats aufweist.

3. Vorrichtung nach den Ansprüchen 1 und 2, dadurch **gekennzeichnet,** daß die Stützplatte (37) Hutform aufweist und mit einem krempenartig ausgebildeten, sich radial nach außen erstreckenden Flansch (38) versehen ist, daß der Substrathaltering (41) auf dem Flansch aufliegt.

4. Vorrichtung nach einem oder mehreren der vorangegangenen Ansprüche, dadurch **gekennzeichnet,** daß der Substrathaltering (41, 57) als Zentrierring für das Substrat ausgebildet ist.

5. Vorrichtung nach einem oder mehreren der vorangegangenen Ansprüche, dadurch **gekennzeichnet,** daß der Substrathaltering (41, 57) im Bereich der Ein- und Ausschleusung als Dichtelement für die Vakuumkammer ausgebildet ist.

6. Vorrichtung nach einem oder mehreren der vorangegangenen Ansprüche, dadurch **gekennzeichnet,** daß der Substrathaltering (41) in der oberen Position der Stützplatte zwischen der Wandung (42) der Vakuumkammer (46), insbesondere der Innenfläche des Deckels der Vakuumkammer, und der Stützplatte (37) dichtend eingeklemmt ist.

## Claims

1. Device for the inward and outward transfer of a workpiece into a vacuum chamber in which there is a transport means for conveying the workpiece, characterised in that a horizontally disposed, disc-shaped transport means is provided having at least one vertical through-aperture, in that, while a workpiece is being transferred inward and outward, a separate holding device is movable vertically within the vertical aperture and pressable against parts of the vacuum chamber, whereby the vacuum chamber is sealed during inward and outward transfer, in that a separate lifting and support device is provided for the vertical movement of the holding device within the vertical aperture and for pressing the holding device against parts of the vacuum chamber, and in that the holding device is substantially formed as a ring (substrate holding ring) which receives the workpiece at its outer edge.

2. Device according to claim 1, characterised in that the substrate holding ring (41, 57) is held in the receiving aperture of the turntable (47, 53) at its outer circumference, preferably by a step, and in that the substrate holding ring has a step extending towards the centre for depositing of the substrate.

3. Device according to claims 1 and 2, characterised in that the support plate (37) is hat-shaped and is provided with a flange (38) formed in the manner of a rim and extending radially outwards, and in that the substrate holding ring (41) rests on the flange.

4. Device according to one or more of the preceding claims, characterised in that the substrate holding ring (41, 57) is formed as a centring ring for the substrate.

5. Device according to one or more of the preceding claims, characterised in that the substrate holding ring (41, 57) is formed as a seal element for the vacuum chamber at the inward and outward transfer channel.

6. Device according to one or more of the preceding claims, characterised in that in the upper position of the support plate, the substrate holding ring (41) is pinched in a sealing-tight manner between the wall (42) of the vacuum chamber (46), in particular the inner face of the cover of the vacuum chamber, and the support plate (37).

## Revendications

1. Dispositif de chargement,par écluse, d'une pièce dans une chambre sous vide, et de son déchargement par écluse, chambre dans laquelle se trouve un moyen de transport pour le transport de la pièce, dispositif caractérisé par le fait qu'est prévu un moyen de transport disposé horizontalement, en forme de plateau, qui présente au moins une ouverture verticale continue, par le fait qu'est également prévu un dispositif, distinct, de maintien de la pièce, ce dispositif de maintien pouvant, lors du chargement et du déchargement, par écluse, d'une pièce, se déplacer à l'intérieur de l'ouverture verticale, selon la direction verticale, et se presser contre des parties de la chambre sous vide, ce par quoi la chambre sous vide est rendue étanche lors du chargement et du déchargement par écluse, et par le fait qu'est prévu un dispositif, distinct, de levage et d'appui pour le mouvement vertical du dispositif de maintien à l'intérieur de l'ouverture verticale et pour le pressage du dispositif de maintien contre des parties de la chambre sous vide, par le fait que le dispositif de maintien a sensiblement la forme d'un anneau (anneau porte-substrat) qui reçoit la pièce dans la zone de son bord extérieur.

2. Dispositif selon la revendication 1, caractérisé par le fait que l'anneau porte-substrat (41, 57) est maintenu, dans la zone de sa périphérie extérieure, de préférence par un gradin, dans l'ouverture réceptrice du platau tournant (47, 53), et que l'anneau porte-substrat présente un gradin, qui s'étend en direction du centre, pour que le substrat s'y pose.

3. Dispositif selon les revendications 1 et 2, caractérisé par le fait que la plaque d'appui (37) présente la forme d'un chapeau et comporte un rebord (38), en forme de crochet, s'étendant radialement vers l'extérieur, et que l'anneau porte-substrat (41) repose sur le rebord.

4. Dispositif selon une ou plusieurs des revendications précédentes, caractérisé par le fait que l'anneau porte-substrat (41, 57) est conçu en tant qu'anneau de centrage pour le substrat.

5. Dispositif selon une ou plusieurs des revendications précédentes, caractérisé par le fait que l'anneau porte-substrat (41, 57) est conçu en tant qu'élément d'étanchéité pour la chambre sous vide dans la zone du chargement et du déchargement par écluse.

6. Dispositif selon l'une ou plusieurs des revendications précédentes, caractérisé par le fait qu'en position haute de la plaque d'appui, l'anneau porte-substrat (41) est bridé, avec étanchéité, entre la paroi (42) de la chambre sous vide (46), en particulier la surface intérieure du couvercle de la chambre sous vide, et la plaque d'appui (37).
